# EUROPEAN PATENT SPECIFICATION

(11) **EP 1 944 386 B1**
(45) Date of publication and mention of the grant of the patent: **03.08.2011**
(21) Application number: 07024285.4
(22) Date of filing: 14.12.2007
(51) Int. Cl.: C23C 14/08

(54) **Transparent conductive film and method for producing the same**
Transparenter, leitfähiger Film und Verfahren zu dessen Herstellung
Film transparent conducteur et son procédé de fabrication

(30) Priority: 10.01.2007 JP 2007002654; 05.02.2007 JP 2007025780
(43) Date of publication of application: 16.07.2008
(73) Proprietor: Nitto Denko Corporation, Ibaraki-shi, Osaka 567-8680 (JP)
(72) Inventor: Sasa, Kazuaki, Ibaraki-shi Osaka 567-8680 (JP); Kawamura, Kazunori, Ibaraki-shi Osaka 567-8680 (JP)
(74) Representative: Müller-Boré & Partner Patentanwälte

(56) References cited:
- DE-A1- 3 639 508
- JP-A- 11 297 640
- US-A1- 2006 008 665
- A. W. OTT, R. P. H. CHANG: "Atomic layer-controlled growth of transparent conducting ZnO on plastic substrates" MATERIALS CHEMISTRY AND PHYSICS, vol. 58, 1999, pages 132-138, XP002474723

## Description

### BACKGROUND OF THE INVENTION

### Field of the Invention

The present invention relates to a method for producing a transparent conductive film. For example, the transparent conductive film obtained by the invention may be used in electrode applications such as transparent electrodes for touch panels and electrodes for film solar cells and other applications including transparent electrodes for advanced display devices such as liquid crystal displays and electroluminescent displays and electromagnetic wave shielding or prevention of static charge of transparent products.

### Description of the Related Art

Recently, demanded types of touch panels, liquid crystal display panels, organic electroluminescent (OLED) panels, electrochromic panels, electronic paper devices, and so on are being changed from conventional devices using transparent electrode-attached glass substrates to devices using film substrates in which transparent electrodes are provided on transparent plastic films. At present, the dominating transparent electrode materials are ITO (In-Sn complex oxide) thin films, but In, a main component of ITO, has a depletion problem. Thus, attention has focused on transparent conductive ZnO-based films which are rich in resources.

The dominating ZnO-based thin films for use in transparent electrodes are GZO films made of Ga-doped ZnO and AZO films made of Al-doped ZnO. Methods for producing these films that have been examined include magnetron sputtering, pulsed laser deposition (PLD), reactive plasma deposition (RPD), and spray techniques. The properties of the ZnO-based thin films obtained by such methods have gradually approached those of ITO films, and their good specific resistance values of the order of 10⁻⁵ Ω·cm are also reported. Their durability such as heat resistance and resistance to moisture and heat has also gradually approached that of ITO films. In most of the reports, however, ZnO-based thin films are formed on heat-resistant substrates such as glass plates at a high temperature of about 300°C, and the examined ZnO-based thin films have thicknesses in the range of 200 to 500 nm, which are considerably thick.

On the other hand, the use of general-purpose organic polymer film substrates has been examined for the formation of ZnO-based thin films thereon. However, organic polymer film substrates can only be heated to 180°C or less. When ZnO-based thin films are formed at this substrate temperature, crystal films can be obtained from an initial film forming stage to an about 150 nm-thick stage. However, the resulting thin films are polycrystalline and low in both mobility (µ) and carrier density (n). When the crystal films are subjected to a heating and humidifying test and then examined for resistance change, their specific resistance is higher than that of thick films with a thickness of 200 nm or more, and there is a problem in which only films whose resistance is extremely changed by the heating and humidifying test are obtainable (Proceedings of the 67th Meeting of the Japan Society of Applied Physics, 31P-ZE-8, "Thickness Dependence of Moisture Resistance of Electrical properties of Transparent Conductive ZnO-Based Films"). Against these problems, there is proposed a ZnO-based thin film made of ZnO doped with not only a Group III element (Ga, Al, and B) but also In (Japanese Patent Application Laid-Open (JP-A) No. 11-297640). In JP-A No. 11-297640, however, In is still used, which only postpones the solution of the problem of In depletion. Further, the resulting 200 nm-thick ZnO-based thin film is evaluated for rate of resistance change in an anti-moisture-and-heat test. In this patent literature, however, the ZnO-based thin film shows a high rate of resistance change in the anti-moisture-and-heat test and thus has insufficient resistance to moisture and heat. It is feared, therefore, that if the ZnO-based thin film becomes thinner, the rate of resistance change will further increase.

It is also proposed that in the process of forming an AZO film on an organic polymer film substrate (such as a polyethylene terephthalate substrate (PET substrate)), a glass-like layer (Al₂O₃ film) should be provided between the PET substrate and the AZO film to reduce the specific resistance (Proceedings of the 67th Meeting of the Japan Society of Applied Physics, 31P-ZE-19, "Transparent Conductive Zinc Oxide-Based Film Formed on PET Substrate by PLD Method"). Here, the glass-like layer (Al₂O₃ film) is formed by pulsed laser deposition (PLD) method, which is poor in productivity, because a relatively thick film with a thickness of 200 to 390 nm must be formed in order to obtain a glass-like film with a smooth surface. In addition, the AZO film formed thereon is as thick as 225 nm, and thus whether the effect can be produced with thin films is open to question.

Ott et al, Materials Chemistry and Physics 58, (1999), pp. 132 - 138, describes the atomic layer-controlled growth of transparent conducting ZnO on a wide variety of substrates where alumina buffer layers are deposited before the ZnO films are deposited on e.g. PET substrates. However, it does not disclose the formation of Al₂O₃ thin films by reactive magnetron sputtering at a specific ultimate vacuum and a specific temperature.

### SUMMARY OF THE INVENTION

It is an object of the invention to provide a method for producing a transparent conductive film that includes an organic polymer film substrate and a ZnO-based thin film formed thereon and has a low resistance value, even when the thickness of the ZnO-based thin film is reduced (particularly to about 150 nm or less), and shows a low rate of resistance change even in a hot and humid environment.

As a result of active investigations for achieving the above objects, the inventors have found that the above objects can be achieved with the method for producing the same as described below so that the invention has been completed.

The method for producing a transparent conductive film of the present invention comprises the steps of: forming an Al₂O₃ thin film on an organic polymer film substrate; and forming a ZnO-based thin film on the Al₂O₃ thin film, the ZnO-based thin film including ZnO doped with at least one of Ga and Al, wherein the step of forming the Al₂O₃ thin film is performed by a reactive magnetron sputtering method in a vacuum device evacuated to an ultimate vacuum of 1x10⁻⁴ Pa or less, while the organic polymer film substrate is heated at a temperature of 80 to 180°C.

In the above, it is preferable that the transparent conductive film, wherein the ZnO-based thin film is a GZO thin film including Ga-doped ZnO. Alternatively, it is preferable that the transparent conductive film, wherein the ZnO-based thin film is an AZO thin film including Al-doped ZnO.

In the above, it is preferable that the transparent conductive film, wherein the Al₂O₃ thin film has a thickness of 20 to 100 nm.

In the above, it is preferable that the transparent conductive film, wherein the ZnO-based thin film has a thickness of 20 to 150 nm.

Furthermore, it is preferable that the method, wherein the Al₂O₃ thin film is produced from Al as a metal target under an oxygen-containing argon gas atmosphere by a reactive magnetron sputtering method.

In the above, it is preferable that the method, wherein the reactive magnetron sputtering method is a reactive dual magnetron sputtering method.

In the above, it is preferable that the method, wherein the step of forming the ZnO-based thin film is performed in a vacuum device evacuated to an ultimate vacuum of 1x10⁻⁴ Pa or less, while the organic polymer film substrate is heated at a temperature of 80 to 180°C.

In the above, it is preferable that the method, wherein the ZnO-based thin film is a GZO thin film produced from ZnO-Ga₂O₃ as an oxide target under an argon gas atmosphere mainly composed of argon gas by a magnetron sputtering method.

In the above, it is preferable that the method, wherein the ZnO-based thin film is a GZO thin film produced from Zn-Ga as a metal target under an oxygen-containing argon gas atmosphere by a reactive magnetron sputtering method. Also, it is preferable that the method, wherein a plasma emission monitor is used to control the amount of the introduction of oxygen into the argon gas atmosphere. Furthermore, it is preferable that the method, wherein the amount of the introduction of oxygen into the argon gas atmosphere is determined at a set point of 50 to 60, wherein the set point corresponds to a Zn plasma emission peak under the oxygen-containing argon gas atmosphere, when a Zn plasma emission peak produced by electric discharge under argon gas only is defined as 90.

In the above, it is preferable that the method, wherein the ZnO-based thin film is an AZO thin film produced from ZnO-Al₂O₃ as an oxide target under an argon gas atmosphere mainly composed of argon gas by a magnetron sputtering method.

In the above, it is preferable that the method, wherein the ZnO-based thin film is an AZO thin film produced from Zn-Al as a metal target under an oxygen-containing argon gas atmosphere by a reactive magnetron sputtering method. Furthermore, it is preferable that the method, a plasma emission monitor (PEM) is used to control the amount of the introduction of oxygen into the argon gas atmosphere.

In the above, it is preferable that the method, further comprising the step of annealing the resulting transparent conductive film at a temperature of 80 to 180°C after the step of forming the ZnO-based thin film.

A transparent conductive film can be produced by forming a ZnO-based thin film, such as a GZO thin film made of Ga-doped ZnO and an AZO thin film made of Al-doped ZnO, directly on an organic polymer film substrate. In this case, if the thickness of the ZnO-based thin film is increased to 200 nm or more, the crystal can grow along the c axis to have a low resistance value so that the rate of resistance change can be low even in a hot and humid environment. Thus, the properties such as resistance to moisture and heat can be significantly improved. On the other hand, although the substrate temperature is low, the ZnO-based thin film with a thickness of about 150 nm or less cannot show sufficient crystal growth along the c axis, has a high resistance value, exhibits a high rate of resistance change also in a hot and humid environment, and thus is very poor in resistance to moisture and heat.

In the transparent conductive film obtained by the invention, the ZnO-based thin film is formed on the organic polymer film substrate with the Al₂O₃ thin film interposed therebetween, so that the ZnO-based thin film even with a thickness of 150 nm or less can satisfy a low resistance value, exhibit a low rate of resistance change even in a hot and humid environment, and have good resistance to moisture and heat.

For example, when the Al₂O₃ thin film is provided between the organic polymer film substrate and the ZnO-based thin film, the resistance of the ZnO-based thin film is lower than that of the ZnO-based thin film formed with the same thickness directly on the organic polymer film substrate. When the ZnO-based thin film is a GZO thin film, the resistance is reduced by 20 to 50%. Particularly when the GZO film is produced from Zn-Ga as a metal target, the rate of the reduction in the resistance value is high. When the ZnO-based thin film is an AZO thin film, the resistance is reduced by about 30%. When the ZnO-based thin film is formed on the Al₂O₃ thin film (not directly on the organic polymer film substrate), the ZnO-based thin film increases in both mobility (µ) and carrier density (n). Thus, it can be considered that the ZnO-thin film has the crystal orientation aligned to the c axis to form a strongly c-axis oriented crystal film so that it can have improved low resistance and improved resistance to moisture and heat. Both the mobility (µ) and the carrier density (n) are increased by annealing, and thus it can be considered that the internal structure of the film is further improved by annealing. In particular, a GZO or AZO thin film produced from a GZM target (Zn-Ga as a metal target) or an AZM target (Zn-Al as a metal target) by reactive sputtering is considered to have more oxygen vacancies in the interior of the thin film than a GZO or AZO thin film produced from a GZO oxide target (ZnO-Ga₂O3 as an oxide target) or an AZO oxide target (ZnO-Al₂O₃ as an oxide target). Thus, it can be considered that crystal rearrangement is facilitated by the oxygen vacancies to improve the low resistance value and the resistance to moisture and heat.

The surface of the resulting Al₂O₃ thin film with a thickness of about 50 nm and the surface of an organic polymer film substrate (for example, a polyethylene terephthalate film) were analyzed with an atomic force microscope (AFM). As a result, both had a surface roughness (Ra) of about 1.2 nm, and thus it was demonstrated that the formation of the Al₂O₃ thin film did not contribute to making the surface smooth. For comparison, SiO₂ thin films formed by sol-gel method and reactive dual magnetron sputtering method, respectively, were evaluated. The SiO₂ thin film formed by sol-gel method had an Ra of 0.3 nm and was very smooth, while the SiO₂ thin film formed by reactive dual magnetron sputtering method had an Ra of 1.4 nm. When a ZnO-based thin film was formed on the substrates (SiO₂ thin films) different in surface properties, the SiO₂ thin film formed by sol-gel method was not effective for low resistance or resistance to moisture and heat, while the SiO₂ thin film formed by reactive dual magnetron sputtering method was effective for low resistance but insufficiently effective for resistance to moisture and heat. These results have demonstrated the effect of the selection and formation of the Al₂O₃ thin film as an undercoat layer on the ZnO-based thin film. It can also be considered that the cause of the fact that the selection and formation of the Al₂O₃ thin film is effective for low resistance and resistance to moisture and heat is not the smoothness of the substrate surface but a kind of epitaxial growth, the incorporation of Al atoms into the film, and so on.

### BRIEF DESCRIPTION OF THE DRAWINGS

Fig. 1 is a schematic cross-sectional view showing an example of the transparent conductive film obtained by the invention;
Fig. 2 is a schematic cross-sectional view showing an example of the laminated transparent conductive film obtained by the invention;
Fig. 3 is a schematic diagram of a device for illustrating a method for producing the transparent conductive film according to the invention;
Fig. 4 is a graph showing the relationship between the resistance of a GZO thin film and SP;
Fig. 5A is a TEM photograph of a cross-section of a GZO thin film of example 1;
Fig. 5B is a TEM photograph of a cross-section of a GZO thin film of comparative example 1; and
Fig. 6 is a graph showing the relationship between the resistance of an AZO thin film and SP.

### DETAILED DESCRIPTION OF THE PREFERRED EMBODIMENTS

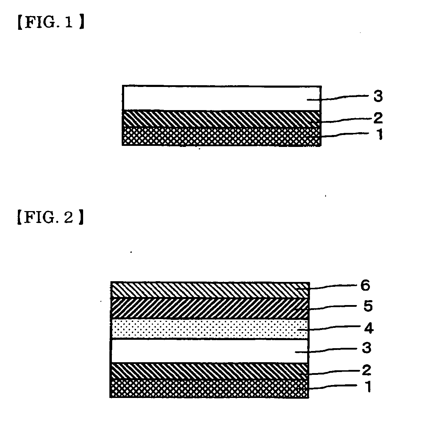

The transparent conductive film obtained by the invention is described below with reference to the drawings. Fig. 1 is a schematic cross-sectional view showing an example of the transparent conductive film obtained by the invention. An Al₂O₃ thin film 2 is formed on one side of an organic polymer film substrate 3 and a ZnO-based thin film 1 is formed on the Al₂O₃ thin film 2.

Fig. 2 is a schematic cross-sectional view showing an example of a laminated transparent conductive film, in which in the transparent conductive film of Fig. 1, a transparent substrate 5 is bonded through a transparent pressure-sensitive adhesive layer 4 to the surface of the organic polymer film substrate 3 which is opposite to the surface on which the GZO thin film 1 is provided. While Fig. 2 shows a case where the transparent substrate 5 is a single layer, a laminate of two or more transparent substrate films with a transparent pressure-sensitive adhesive layer interposed therebetween may be used as the transparent substrate 5. Fig. 2 also illustrates a case where a hard coating layer 6 (a resin layer) is formed on the outer surface of the transparent substrate 5.

The structure shown in Fig. 1 may be used for a general electrode. For applications required to be reliable for bending, such as transparent electrodes for touch panels and electrodes for film solar cells, a laminate with a transparent substrate is preferably used, and the structure shown in Fig. 2 is particularly preferred. If such a structure is used for touch panels, durability against pen or writing conditions can be improved.

The organic polymer film substrate for use in the invention is preferably excellent in transparency, heat resistance and surface smoothness. Examples of materials for such a film substrate include polyester-based polymers such as polyethylene terephthalate and polyethylene naphthalate, polyolefin-based polymers, polycarbonate, polyethersulfone, polyarylate, polyimide, and polymers of a single component such as norbornene and the like or copolymers thereof. An epoxy-based film and the like may also be used as the organic polymer film substrate.

The thickness of the organic polymer film substrate to be used is generally from 16 to 200 µm, preferably from 25 to 125 µm, while it may depend on the film production conditions or applications.

A sputtering method is used to form the Al₂O₃ thin film on the organic polymer film substrate. It is preferred that the surface of the organic polymer film substrate on which a film is to be formed by sputtering should be smooth and have no irregularities. Thus, the surface of the organic polymer film substrate on which the Al₂O₃ thin film is to be formed preferably has a surface roughness (Ra) of 1.5 nm or less with respect to 1 µm square measured with an atomic force microscope (AFM).

Before the Al₂O₃ thin film is formed, a surface modification process (pretreatment) such as plasma treatment under an inert gas atmosphere such as argon gas and nitrogen gas may be performed on the organic polymer film substrate, depending on the type of the film. The Al₂O₃ thin film can be formed on the organic polymer film substrate with an undercoat film such as a SiO₂ thin film interposed therebetween for the purpose of antireflection or the like.

The other surface of the organic polymer film substrate on which no Al₂O₃ thin film will be formed may be previously subjected to etching or priming treatment such as sputtering, corona discharge, flame treatment, ultraviolet irradiation, electron beam irradiation, chemical conversion, and oxidation so as to have improved adhesion to a pressure-sensitive adhesive layer for use in attachment to the transparent substrate. A backside coat layer or a hard coat layer may also be formed on the surface where no Al₂O₃ thin film will be formed.

It can be considered that the cause of the fact that advantages such as low resistance value and resistance to moisture and heat are obtained by forming the Al₂O₃ thin film is not the smoothness of the substrate surface but a kind of epitaxial growth, the incorporation of Al atoms into the film and so on. Thus, the Al₂O₃ thin film is formed by vacuum film-forming method. Particularly usable are RF magnetron sputtering methods including using Al₂O₃ as an oxide target and forming a film under an inter gas atmosphere such as argon gas and reactive magnetron sputtering methods including using Al as a metal target and forming a film under an atmosphere containing oxygen and an inert gas such as argon gas. Above all, reactive magnetron sputtering methods are employed in view of film forming speed and damage to the substrate.

Magnetron sputtering methods include single magnetron sputtering methods, in which a single target piece is attached to the magnet electrode, and dual magnetron sputtering methods, in which two target pieces are attached to magnet electrodes, respectively. In the invention, dual magnetron sputtering methods are preferably used. In dual magnetron sputtering methods, two target pieces fixed on the respective magnet electrodes are alternately used during film production by electric discharge with a medium frequency (MF) power source, in which one target is used for electric discharge to form a film, while a weak reverse charge is applied to the other target to cancel the charge of the target surface, so that a film can be stably produced even when the target surface conduction is not good due to an oxide such as Al₂O₃ during film production. In the invention, therefore, the Al₂O₃ thin film is preferably formed by reactive dual magnetron sputtering method.

A case where the Al₂O₃ thin film is formed by a reactive magnetron sputtering method is described below. In a reactive magnetron sputtering method, the Al₂O₃ thin film is produced from Al as a metal target under an oxygen-containing argon gas atmosphere. In this process, the supply of oxygen gas into the device is generally controlled by a plasma control method in which a plasma emission monitor controller (PEM) is used to detect the plasma intensity in the electric discharge so that the amount of the reactant gas (oxygen gas) is feedback controlled, or by an impedance control method in which the same PEM is used to detect the impedance of the electric discharge (the resistance value of the electric discharge) so that the amount of the introduction of gas (oxygen gas) is changed to a specific value based on the detected impedance. The PEM device may be PEM05 manufactured by Von Ardenne Anlagentechnik GmbH (Germany). This device may be used in both of the plasma control method and the impedance control method. The impedance control method is preferably used in forming the Al₂O₃ film, because it allows stable control.

In the impedance control method, argon gas (in a constant amount) is generally introduced as a sputtering gas, while the impedance value is adjusted with PEM so as to produce the desired film quality. Oxygen gas is then introduced and controlled every moment with a piezo-valve to achieve a specified impedance of the electric discharge so that a film of constant quality can be formed on the organic polymer film substrate. For example, when the MF power is 3 kw, the set point (SP) of the PEM, which is an index of the impedance, is preferably controlled to 19 to 23, more preferably to 20 to 22. If the SP is more than 23, the amount of the introduction of oxygen can be insufficient so that the Al₂O₃ thin film can cause absorption to reduce light transmittance. If the SP is less than 19, excessive oxidation can proceed to reduce the film forming speed. The SP is used as the reference for the absolute value of the impedance. When the SP is 22, therefore, the impedance value is about 22.3 Ω=261 V/ 11.7 A. If the SP is set smaller, the impedance becomes smaller. In this case, the PEM opens the oxygen valve to introduce more oxygen.

When sputtering is used to form the Al₂O₃ thin film on the organic polymer film substrate, the organic polymer film substrate may be heated, while the device may be evacuated or degassed, in order to reduce gas generation from the film or water adsorption as much as possible. For example, the Al₂O₃ thin film may be formed on the organic polymer film substrate in a vacuum device equipped with a heater. In the vacuum device, the ultimate vacuum may be set at 1x10⁻⁴ Pa or less, preferably at 2x10⁻⁵ Pa or less. The organic polymer film substrate is preferably heated at a temperature of about 80 to about 180°C, preferably of 100 to 150°C. For example, the heater may be a heating roller. The film is generally produced under a pressure of about 0.01 to about 1 Pa, preferably of 0.1 to 0.6 Pa.

The Al₂O₃ thin film should generally have a thickness of about 20 to about 100 nm, preferably have a thickness in the range of 40 to 70 nm, in view of productivity, stability of film quality or cracking.

A ZnO-based thin film made of ZnO doped with at least one of Ga and Al is formed on the Al₂O₃ thin film so that the transparent conductive film of the invention is produced. Examples of the ZnO-based thin film include a GZO thin film made of Ga-doped ZnO and an AZO thin film made of Al-doped ZnO and also include a ZnO-based thin film made of ZnO doped with Ga and Al. The ZnO-based thin film may be formed using a vacuum film-forming method such as magnetron sputtering, pulsed laser deposition (PLD) and reactive plasma deposition (RPD). In view of productivity and properties, magnetron sputtering would be common.

Any of two different magnetron sputtering methods may be used to form the ZnO-based thin film. In one method, the film is produced by sputtering from an oxide target under an argon gas atmosphere mainly composed of argon gas. Examples of the oxide target include a ZnO-Ga₂O₃ sintered body and a nO-Al₂O₃ sintered body. Only argon gas or a mixture of argon gas and a small amount of hydrogen gas may be used as the argon gas atmosphere. The content of Ga₂O₃ in the ZnO-Ga₂O₃ sintered body is generally from about 1 to about 10% by weight, preferably from 4 to 8% by weight, in view of a reduction in the specific resistance of the resulting film, while it may be determined as appropriate. The content of Al₂O₃ in the ZnO-Al₂O₃ sintered body is generally from about 0.5 to about 8% by weight, preferably from 1 to 5% by weight, in view of a reduction in the specific resistance of the resulting film, while it may be determined as appropriate.

The other method is a reactive magnetron sputtering method in which the film is produced by sputtering from a metal target under an oxygen-containing argon gas atmosphere. Examples of the metal target include Zn-Ga, Zn-Al and the like. It can be considered that Zn-Ga as a metal target is not completely alloyed but is a uniform dispersion of Ga in Zn metal. The content of Ga in the Zn-Ga is generally from about 0.4 to about 4% by weight, preferably from 1.6 to 3.2% by weight, in view of a reduction in the specific resistance of the resulting film, similarly to the oxide target, while it may be determined as appropriate. A Zn-Al alloy may be used as the Zn-Al metal target. The content of Al in the Zn-Al alloy is generally from about 0.2 to about 4% by weight, preferably from 0.5 to 2.5% by weight, in view of a reduction in the specific resistance of the resulting film, similarly to the oxide target, while it may be determined as appropriate.

Since the organic polymer film substrate is used in the formation of the ZnO-based thin film, the film should be formed at low temperature, and even a thin film with a thickness of 150 nm or less should be improved with respect to low resistance value and resistance to moisture and heat (low rate of resistance change). For these purposes, it is desired to grow a crystal oriented along the c axis from the interface of the substrate on which the ZnO-based thin film is formed, to continuously grow a hexagonal crystal in the XY direction, and to replace Zn with Ga and/or Al at many ZnO crystal sites for donor release. From these points of view, the ZnO-based thin film according to the invention is preferably formed by reactive magnetron sputtering method using Zn-Ga and/or Zn-Al, which are metal targets capable of introducing a number of oxygen vacancies.

Magnetron sputtering method is generally performed using a ZnO-Ga₂O₃ sintered body as an oxide target and/or a ZnO-Al₂O₃ sintered body as an oxide target under an argon gas atmosphere mainly composed of argon gas. At present, however, such oxide targets have high oxygen content, and thus a ZnO-based thin film containing a large amount of oxygen can only be produced even under argon gas only. Even through hydrogen gas is introduced into the argon gas atmosphere to remove the oxygen component, only a little improvement can be achieved. Particularly when a ZnO-based thin film with a thickness of 150 nm or less is produced, the resulting polycrystalline film can be easily cracked and have a low carrier concentration (n). The film produced with the oxide target at low temperature is an oxygen-excessive film which has less oxygen vacancies to allow less atomic movement and thus is less likely to have an ideal structure than that produced by reactive magnetron sputtering method.

The case where the ZnO-based thin film is produced by reactive magnetron sputtering method is specifically described below. The ZnO-based thin film is preferably produced by a reactive single magnetron sputtering method with a single target attached to a magnet electrode. Specifically, the method includes preparing Zn-Ga as a metal target and/or Zn-Al as a metal target and producing the ZnO-based thin film, while controlling the amount of the introduction of oxygen by plasma control with a plasma emission monitor controller (PEM) during electric discharge with a DC power source. In the plasma control with the PEM, the plasma intensity is detected (for Zn) and then controlled to a set value by controlling the amount of oxygen gas. The PEM for the plasma control is a kind of film-thickness controller which can control the film forming speed by oxidation, in which the film forming speed depends on the film quality.

The set point (SP) of the PEM is preferably controlled to 45 to 70. When the ZnO-based thin film is a GZO thin film, the SP is preferably controlled to 50 to 60, more preferably to 52 to 56. When the ZnO-based thin film is an AZO thin film, the SP is preferably controlled to 50 to 60, more preferably to 52 to 58. The SP set at 90 (SP=90) in the plasma monitor of the PEM may indicate the Zn plasma emission peak when electric discharge is performed under argon gas only. When this case is used as the reference and when electric discharge is performed under an oxygen-containing argon gas atmosphere in a similar manner, the SP can indicates the Zn plasma emission peak and provide an index of the amount of the introduction of oxygen.

The PEM device may be PEM05 manufactured by Von Ardenne Anlagentechnik GmbH (Germany). If the ultimate vacuum is insufficient, oxygen gas would be contained in advance so that the SP value for only argon gas cannot be precisely set at 90. Thus, the ultimate vacuum as described later should be reached in the interior of the chamber before the film production.

When sputtering is used to form the ZnO-based thin film on the organic polymer film substrate, gas generation from the film and water adsorption should be reduced as much as possible so that the properties (anti-moisture-and-heat properties for the resistance value) of the produced ZnO-based thin film can be improved. Before the ZnO-based thin film is formed, therefore, evacuation or degassing is preferably performed, while the organic polymer film substrate is heated. For example, the formation of the ZnO-based thin film on the organic polymer film substrate is preferably performed in a vacuum device equipped with a heater. In the vacuum device, the ultimate vacuum may be set at 1x10⁻⁴ Pa or less, preferably at 2x10⁻⁵ Pa or less, and a gas component, particularly water, is preferably removed. The organic polymer film substrate is preferably heated at a temperature of about 80 to about 180°C, preferably of 100 to 150°C. For example, the heater may be a heating roller. The film is generally formed under a pressure of about 0.01 to about 1 Pa, preferably of 0.1 to 0.6 Pa.

In general, the ZnO-based thin film preferably has a thickness of about 20 to about 150 nm and is also favorable even when it has a thickness of 150 nm or less. In view of transmittance and resistance value for touch panel applications, the thickness of the ZnO-based thin film is preferably in the range of 30 to 80 nm.

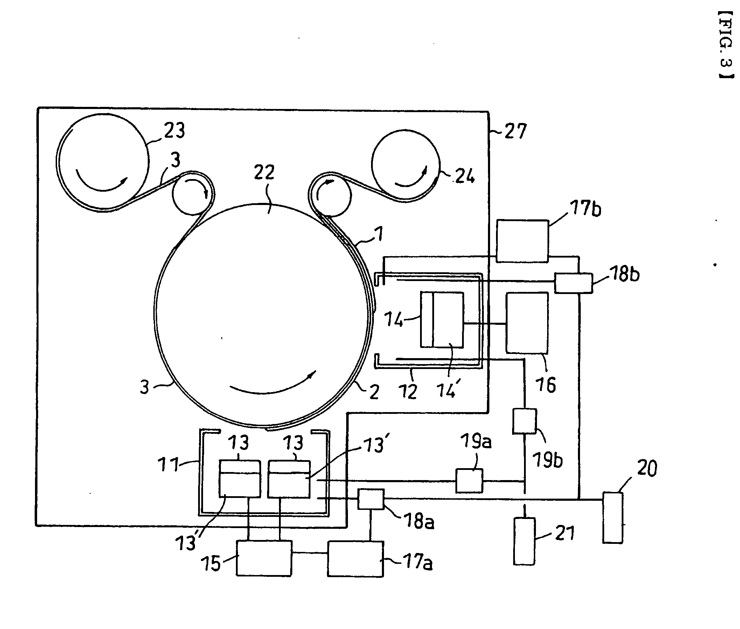

The formation of the Al₂O₃ thin film on the organic polymer film substrate and the formation of the ZnO-based thin film thereafter may be independently performed in different processes or may be performed in a continuous process. Fig. 3 shows a case where the formation of the Al₂O₃ thin film on the organic polymer film substrate and the formation of the ZnO-based thin film thereafter are continuously performed in a single vacuum device.

Fig. 3 shows an example where in a sputter deposition device (vacuum device 27), an Al₂O₃ thin film is formed on an organic polymer film substrate 3 by reactive magnetron sputtering at a dual magnetron sputtering device 11, and then a ZnO-based thin film is formed by reactive magnetron sputtering at a single magnetron sputtering device 12. In the vacuum device 27, the organic polymer film substrate 3 is fed from a feeding roller 23, transferred by means of a heating roller electrode 22 through a guide roller 25, and wound by means of a take-up roller 24 through a guide roller 26. When one side of the organic polymer film substrate 3 undergoes surface treatment, the organic polymer film substrate 3 is fed such that the Al₂O₃ thin film can be formed on a smooth surface that does not undergo smoothing treatment. The vacuum device 27 is evacuated so as to have a given pressure or less (evacuating means is not shown in the drawing). The heating roller 22 is controlled so as to have a given temperature.

The dual magnetron sputtering device 11 includes two Al targets 13 mounted on magnet electrodes 13', respectively, from which electric discharge is alternately performed with an MF power source 15, when the Al₂O₃ thin film 2 is formed on the organic polymer film substrate 3. In the dual magnetron sputtering device 11, the impedance of the electric discharge from the MF power source 15 is detected by a plasma emission monitor controller (PEM) 17a and controlled to a preset impedance of electric discharge by a piezo-valve 18a such that argon gas 21 and oxygen gas 20 can produce a given SP. The argon gas 21 is controlled by a mass flow controller (MFC) 19a.

In the single magnetron sputtering device 12 with a single metal target 14 (Zn-Ga and/or Zn-Al) mounted on a magnet electrode 14', electric discharge is then performed from a DC power source 16, so that the ZnO-based thin film 1 is formed on the Al₂O₃ thin film 2. In the single magnetron sputtering device 12, plasma control on the DC power source 16 is performed by a plasma emission monitor controller (PEM) 17b, and a piezo-valve 18b is used for the control such that argon gas 21 and oxygen gas 20 can produce a given SP. The argon gas 21 is controlled by a mass flow controller (MFC) 19b.

The resulting transparent conductive film including the organic polymer film substrate, the Al₂O₃ thin film formed thereon and the ZnO-based thin film formed thereafter may be subjected to the process of annealing it at a temperature of 80 to 180°C. The annealing process is preferably performed at a temperature of 130 to 160°C. In general, the time of the annealing process is preferably from about 30 minutes to about 24 hours, more preferably from 1 to 10 hours. While the annealing process is generally performed in the air, it may be performed under reduce pressure or vacuum.

When the annealing process is performed, the rate of change in the resistance value can be controlled to be low even under a hot and humid environment so that the resistance to moisture and heat can be increased. Particularly when the ZnO-based thin film produced from Zn-Ga as a metal target and/or Zn-Al as a metal target by reactive magnetron sputtering method is subjected to the annealing process, there is almost no increase in the resistance of the ZnO-based thin film, and a significant improvement in the resistance to moisture and heat can be shown. It is assumed that this is because the ZnO-based thin film produced from Zn-Ga as the metal target and/or Zn-Al as the metal target is rich in an oxygen-deficient state so that crystal rearrangement can be caused by the vacancies.

As shown in Fig. 2, a transparent substrate 5 may be bonded to the surface of the organic polymer film substrate 3 of the resulting transparent conductive film with a transparent pressure-sensitive adhesive layer 4 interposed therebetween.

The lamination may be performed by a process including forming the pressure-sensitive adhesive layer 4 on the transparent substrate 5 and then bonding the organic polymer film substrate 3 thereto or by a process including forming the pressure-sensitive adhesive layer 4 on the organic polymer film substrate 3 contrary to the above and then bonding the transparent substrate 5 thereto. The latter process allows continuous production of the pressure-sensitive adhesive layer 4 with the organic polymer film substrate 3 provided in the form of a roll and thus is more advantageous in view of productivity.

The pressure-sensitive adhesive may be of any type having transparency, and for example, an acryl-based pressure-sensitive adhesive, a silicone-based pressure-sensitive adhesive, a rubber-based pressure-sensitive adhesive, or the like may be used. After the bonding of the transparent substrate, the pressure-sensitive adhesive layer has a cushion effect and thus can function to improve the scratch resistance of the conductive thin film formed on one side of the film substrate or to improve the tap properties thereof for touch panels. In order to perform this function better, it is preferred that the elastic modulus of the pressure-sensitive adhesive layer should be set in the range of 1 to 100 N/cm² and that its thickness should be set at 1 µm or more, generally in the range of 5 to 100 µm.

If the elastic modulus is less than 1 N/cm², the pressure-sensitive adhesive layer can be inelastic so that it can easily deform by pressing to make the film substrate irregular and further to make the conductive thin film irregular, and the pressure-sensitive adhesive can also easily squeeze out of the cut section, the effect of improving the scratch resistance of the conductive thin film or improving the tap properties of the thin film for touch panels can be reduced. If the elastic modulus is more than 100 N/cm², the pressure-sensitive adhesive layer can be hard, and the cushion effect cannot be expected, so that the scratch resistance of the conductive thin film or the tap properties thereof for touch panels cannot be improved.

If the thickness of the pressure-sensitive adhesive layer is less than 1 µm, the cushion effect also cannot be expected so that the scratch resistance of the conductive thin film or the tap properties thereof for touch panels cannot be expected. If the pressure-sensitive adhesive layer is too thick, it can reduce the transparency, or it can be difficult to obtain good results on the formation of the pressure-sensitive adhesive layer, the bonding workability of the transparent substrate, and the cost.

The transparent substrate bonded through the pressure-sensitive adhesive layer as described above imparts good mechanical strength to the film substrate and particularly contributes to the prevention of curling and the like.

The transparent substrate 5 may be a monolayer structure as shown in Fig. 2. Alternatively, the transparent substrate 5 may be a composite structure of two or more transparent substrate films bonded to one another with a transparent pressure-sensitive adhesive layer, which can form a laminate having increased mechanical strength and so on as a whole. For example, two or more transparent substrate films may be bonded to one another with a transparent pressure-sensitive adhesive layer to form the transparent substrate 5.

A description is given of the case that a monolayer structure is used as the transparent substrate. When the transparent conductive film is required to be flexible even after the transparent substrate of a monolayer structure is bonded, a plastic film with a thickness of about 6 to about 300 µm is generally used as the transparent substrate. When flexibility is not particularly required, a glass plate with a thickness of about 0.05 to about 10 mm or a plastic film or plate with a thickness of about 0.05 to about 10 mm is generally used as the transparent substrate. Examples of the plastic material include those described above for the film substrate.

When a composite structure is used as the transparent substrate, the thickness of the transparent substrate may be the same as the above. The thickness of the transparent substrate of the composite structure is the total thickness of a laminate of two or more transparent substrate films bonded to one another with a transparent pressure-sensitive adhesive layer. Specifically, when the transparent conductive film is required to be flexible even after the transparent substrate of the composite structure is bonded, the thickness of the transparent substrate of the composite structure is generally from about 6 to about 300 µm. In this case, the two or more transparent substrate films to be used may be plastic films that are of the same type as the film substrate. When flexibility is not particularly required, the thickness of the transparent substrate is generally from about 0.05 to about 10 mm. In this case, glass plates or plastic films or plates may be used as the two or more transparent substrate films. These may also be used in combination. Examples of the plastic material include those described above for the film substrate.

In the transparent substrate of the composite structure, the material described above for the lamination of the transparent substrate and the film substrate is preferably used for the transparent pressure-sensitive adhesive layer for bonding two or more transparent substrate films.

If necessary, an antiglare or antireflection layer for improving visibility or a hard coat layer for protecting the outer surface may be formed on the outer surface of the transparent substrate (the surface opposite to the pressure-sensitive adhesive layer). For example, a cured coating film made from a curable resin such as a melamine resin, a urethane resin, an alkyd resin, an acryl-based resin, or a silicon-based resin is preferably used as the hard coat layer.

A too thin hard coat layer may have insufficient hardness, while a too thick hard coat layer can be cracked. Also in view of curl preventing properties and so on, the thickness of the hard coat layer is preferably from about 0.1 to about 30 µm.

### EXAMPLES

The invention is described below with reference to some examples which are not intended to limit the scope of the invention. The invention is more specifically described by showing the examples below which are not intended to limit the scope of the invention.

### Examples 1

### Organic Polymer Film Substrate

The organic polymer film substrate used was a polyethylene terephthalate (PET) film 0300E (100 µm in thickness) manufactured by Mitsubishi Plastics Inc.

### Pretreatment

The PET film was placed in a sputter deposition device as shown in Fig. 3 such that an Al₂O₃ thin film was able to be formed on its smooth surface (not undergoing smoothing treatment) of the PET film. The roller electrode used was heated to 120°C. While the film was wound, degassing was performed with an evacuation device including a cryocoil and a turbopump so that an ultimate vacuum of 1.5x10⁻⁶ Pa was achieved. Argon gas was then introduced, and the film was allowed to pass through plasma discharge at 13.56 MHz so that the PET surface was pretreated.

### Formation of Al₂O₃ Thin Film (Undercoat Layer)

Al as a target was then mounted on each electrode of the dual magnetron sputtering device of Fig. 3. While argon gas was introduced at 150 sccm (air-equivalent gas flow rate, cc/minute), oxygen gas was introduced under PEM impedance control during an MF discharge of 3 kw so that an Al₂O₃ thin film was formed. The film was produced under a pressure of 0.3 Pa, and the SP was set at 22. The resulting Al₂O₃ thin film had a thickness of about 50 nm.

### Formation of GZO Thin Film

Zn-2.4% by weight Ga (Zn-Ga with a Ga content of 2.4% by weight) as a metal target was then mounted on the electrode of the single magnetron sputtering device. A GZO thin film was formed by an electric discharge with a DC power of 3 kw under PEM plasma control so that a transparent conductive film was obtained. The amount of the introduction of the argon gas was 300 sccm, and the SP of the PEM was set at 54. The film was produced under a pressure of 0.33 Pa, and the GZO thin film had a thickness of about 40 nm.

### Example 2

A transparent conductive film was obtained in the same manner as in example 1, except that the GZO thin film was formed by the method described below.

### Formation of GZO Thin Film

The target for producing the GZO thin film was replaced with ZnO-5.7% by weight Ga₂O₃ (ZnO-Ga₂O₃ with a Ga₂O₃ content of 5.7% by weight) as an oxide target, and the film was formed under only argon gas with a DC power of 3 kw. The amount of the introduction of the argon gas was 300 sccm, and the film was produced under a pressure of 0.3 Pa. The GZO thin film had a thickness of about 40 nm.

### Example 3

### Preparation of Transparent Conductive Film

A transparent conductive film was obtained in the same manner as in example 1, except that a PET film with a thickness of 23 µm was used instead as the organic polymer film substrate.

### Preparation of Laminated Transparent Conductive Film

An ultraviolet-cured hard coat layer with a thickness of 7 µm was formed on one side of a PET film with a thickness of 125 µm to form a transparent substrate to be used. A transparent acryl-based pressure-sensitive adhesive was applied to the non-hard-coated surface of the transparent substrate (PET film) to form a 25 µm-thick pressure-sensitive adhesive layer. The transparent conductive film (the surface of the 23 µm-thick PET film where neither Al₂O₃ thin film nor GZO thin film was formed) was bonded to the pressure-sensitive adhesive layer with a laminating roller so that a laminated transparent conductive film was obtained.

### Comparative Example 1

A transparent conductive film was obtained in the same manner as in example 1, except that the process of forming the Al₂O₃ thin film was omitted.

### Comparative Example 2

A transparent conductive film was obtained in the same manner as in example 2, except that the process of forming the Al₂O₃ thin film was omitted.

### Comparative Example 3

A transparent conductive film was obtained in the same manner as in example 1, except that a SiO₂ thin film was formed in place of the Al₂O₃ thin film by the method described below.

### Formation of SiO₂ Thin Film

In the process of example 1, a Si target was used in place of the Al target, and while argon gas was introduced at 150 sccm, oxygen gas was introduced under PEM impedance control during an MF discharge of 6 kw so that a SiO₂ thin film was formed. The film was produced under a pressure of 0.3 Pa, and the SP was set at 40. The resulting SiO₂ thin film had a thickness of about 50 nm.

### Comparative Example 4

A transparent conductive film was obtained in the same manner as in example 2, except that a SiO₂ thin film was formed in place of the Al₂O₃ thin film by the method described below.

### Formation of SiO₂ Thin Film

In the process of example 1, a Si target was used in place of the Al target, and while argon gas was introduced at 150 sccm, oxygen gas was introduced under PEM impedance control during an MF discharge of 6 kw so that a SiO₂ thin film was formed. The film was produced under a pressure of 0.3 Pa, and the SP was set at 40. The resulting SiO₂ thin film had a thickness of about 50 nm.

### Examples 4

### Organic Polymer Film Substrate

The organic polymer film substrate used was a polyethylene terephthalate (PET) film 0300E (100 µm in thickness) manufactured by Mitsubishi Plastics Inc.

### Pretreatment

The PET film was placed in a sputter deposition device as shown in Fig. 3 such that an Al₂O₃ thin film was able to be formed on its smooth surface (not undergoing smoothing treatment) of the PET film. The roller electrode used was heated to 120°C. While the film was wound, degassing was performed with an evacuation device including a cryocoil and a turbopump so that an ultimate vacuum of 1.5x10⁻⁶ Pa was achieved. Argon gas was then introduced, and the film was allowed to pass through plasma discharge at 13.56 MHz so that the PET surface was pretreated.

### Formation of Al₂O₃ Thin Film (Undercoat Layer)

Al as a target was then mounted on each electrode of the dual magnetron sputtering device of Fig. 3. While argon gas was introduced at 150 sccm (air-equivalent gas flow rate, cc/minute), oxygen gas was introduced under PEM impedance control during an MF discharge of 3 kw so that an Al₂O₃ thin film was formed. The film was produced under a pressure of 0.3 Pa, and the SP was set at 22. The resulting Al₂O₃ thin film had a thickness of about 50 nm.

### Formation of AZO Thin Film

Zn-1.5% by weight Al (Zn-Al with an Al content of 1.5% by weight) as a metal target was then mounted on the electrode of the single magnetron sputtering device. An AZO thin film was formed by an electric discharge with a DC power of 3 kw under PEM plasma control so that a transparent conductive film was obtained. The amount of the introduction of the argon gas was 300 sccm, and the SP of the PEM was set at 54. The film was produced under a pressure of 0.33 Pa, and the AZO thin film had a thickness of about 40 nm.

### Example 5

A transparent conductive film was obtained in the same manner as in example 4, except that the AZO thin film was formed by the method described below.

### Formation of AZO Thin Film

The target for producing the AZO thin film was replaced with ZnO-3% by weight Al₂O₃ (ZnO-Al₂O₃ with an Al₂O₃ content of 3% by weight) as an oxide target, and the film was formed under only argon gas with a DC power of 3 kw. The amount of the introduction of the argon gas was 300 sccm, and the film was produced under a pressure of 0.3 Pa. The AZO thin film had a thickness of about 40 nm.

### Example 6

### Preparation of Transparent Conductive Film

A transparent conductive film was obtained in the same manner as in example 4, except that a PET film with a thickness of 23 µm was used instead as the organic polymer film substrate.

### Preparation of Laminated Transparent Conductive Film

An ultraviolet-cured hard coat layer with a thickness of 7 µm was formed on one side of a PET film with a thickness of 125 µm to form a transparent substrate to be used. A transparent acryl-based pressure-sensitive adhesive was applied to the non-hard-coated surface of the transparent substrate (PET film) to form a 25 µm-thick pressure-sensitive adhesive layer. The transparent conductive film (the surface of the 23 µm-thick PET film where neither Al₂O₃ thin film nor AZO thin film was formed) was bonded to the pressure-sensitive adhesive layer with a laminating roller so that a laminated transparent conductive film was obtained.

### Comparative Example 5

A transparent conductive film was obtained in the same manner as in example 4, except that the process of forming the Al₂O₃ thin film was omitted.

### Comparative Example 6

A transparent conductive film was obtained in the same manner as in example 5, except that the process of forming the Al₂O₃ thin film was omitted.

### Comparative Example 7

A transparent conductive film was obtained in the same manner as in example 4, except that a SiO₂ thin film was formed in place of the Al₂O₃ thin film by the method described below.

### Formation of SiO₂ Thin Film

In the process of example 4, a Si target was used in place of the Al target, and while argon gas was introduced at 150 sccm, oxygen gas was introduced under PEM impedance control during an MF discharge of 6 kw so that a SiO₂ thin film was formed. The film was produced under a pressure of 0.3 Pa, and the SP was set at 40. The resulting SiO₂ thin film had a thickness of about 50 nm.

### Comparative Example 8

A transparent conductive film was obtained in the same manner as in example 5, except that a SiO₂ thin film was formed in place of the Al₂O₃ thin film by the method described below.

### Formation of SiO₂ Thin Film

In the process of example 1, a Si target was used in place of the Al target, and while argon gas was introduced at 150 sccm, oxygen gas was introduced under PEM impedance control during an MF discharge of 6 kw so that a SiO₂ thin film was formed. The film was produced under a pressure of 0.3 Pa, and the SP was set at 40. The resulting SiO₂ thin film had a thickness of about 50 nm.

The transparent conductive films (including the laminated transparent conductive films) obtained by the examples and the comparative examples were evaluated as described below. The results on examples 1 to 3 and comparative examples 1 to 4 are shown in table 1, and those on examples 4 to 6 and comparative examples 5 to 8 are shown in table 2.

### Initial Resistance Value

The resistance value (Ro, Ω/square) of each transparent conductive film was measured with Loresta manufactured by Mitsubishi Chemical Corporation.

### Resistance to Moisture and Heat

The transparent conductive films were allowed to stand in an environment at 150°C for 1 hour or 10 hours and then measured for resistance value by the above method. These samples were also placed in a thermo-hygrostat at 85°C and 85%RH for 250 hours and then measured for resistance value by the above method so that a change in resistance under heat and moisture was evaluated. The change in resistance under heat and moisture was expressed by the ratio (times) of the increased resistance value after the standing under heat and moisture to the initial resistance value.

The laminated transparent conductive film obtained in each of examples 3 and 6 and a glass ITO substrate were laminated with a spacer such that the conductive film (GZO thin film) of the laminated transparent conductive film was opposed to the ITO substrate, so that a touch panel was formed. The touch panel was subjected to a test for durability to character input with a 0.8 ϕ Delrin pen. The result was substantially comparable to that of the same durability test performed on a touch panel using glass ITO substrates as both touch panel substrates.

**Table 1**

| | Presence or Absence of Transparent Substrate | Organic Polymer Film Substrate | Undercoat Layer | Target for GZO Thin Film | Evaluations | | | | |
|---|---|---|---|---|---|---|---|---|---|
| | | | | | Initial Resistance (Ro, Ω/square) | Resistance to Moisture and Heat | | | |
| | | | | | | 150°C for 1 Hour | | 150°C for 10 Hour | |
| | | | | | | Resistance (Ω/square) | 85°C and 85%RH for 250 Hours (times) | Resistance (Ω/square) | 85°C and 85%RH for 250 Hours (times) |
| Example 1 | Absence | PET | Al₂O₃ | GZM | 305 | 287 | 1.88 | 305 | 1.09 |
| Example 2 | Absence | PET | Al₂O₃ | GZO | 316 | 385 | 1.64 | 773 | 1.29 |
| Example 3 | Presence | PET | Al₂O₃ | GZM | 310 | 300 | 1.67 | - | - |
| Comparative Example 1 | Absence | PET | Absence | GZM | 598 | 1063 | 85.5 | 3445 | 2.37 |
| Comparative Example 2 | Absence | PET | Absence | GZO | 410 | 643 | 30.8 | 1800 | 4.03 |
| Comparative Example 3 | Absence | PET | SiO₂ | GZM | 356 | 447 | 26.5 | 966 | 1.85 |
| Comparative Example 4 | Absence | PET | SiO₂ | GZO | 425 | 392 | 9.31 | 529 | 1.59 |

Table 1 indicates that each example shows a relatively low resistance value, a relatively small change in the resistance value under heat or under heat and moisture, and both good heat resistance and good resistance to moisture and heat. It is also apparent that in each example, the resistance to moisture and heat is improved by the annealing process in an environment at 150°C.

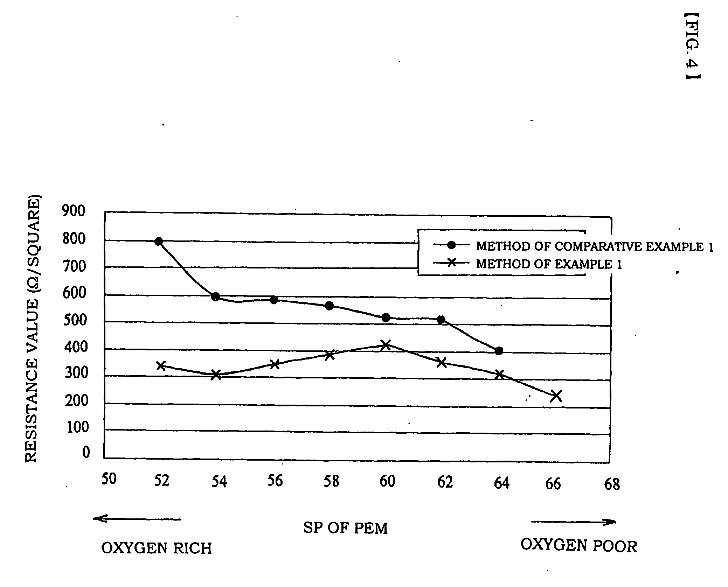

Fig. 4 is a graph showing the relationship between the SP and the resistance value with respect to the GZO thin films formed in the same manner as in example 1 (in which only the SP was changed) and in the same manner as in comparative example 1 (in which only the SP was changed). Fig. 4 also indicates that the resistance value is significantly reduced when the GZO thin film is formed on the Al₂O₃ thin film. In the absence of the undercoat layer of the Al₂O₃ thin film, an increase in the amount of the introduction of oxygen results in a reduction in the oxygen vacancies of the GZO thin film so that the release of carrier electrons from the oxygen vacancies can decrease, and thus the resistance value can increase. On the other hand, in the presence of the Al₂O₃ thin film, the resistance value increases until the SP reaches 60, but the resistance value decreases until the SP reaches 54. This may be because of a change of the film structure. When the SP exceeds 60, the transmittance becomes 50% or less, and thus this case is not preferred in view of transparency. From these points of view, the SP is preferably from 50 to 60, more preferably from 52 to 56. In the above SP range, good transparency is provided. Also in the above SP range, annealing is significantly effective in improving the resistance to moisture and heat.

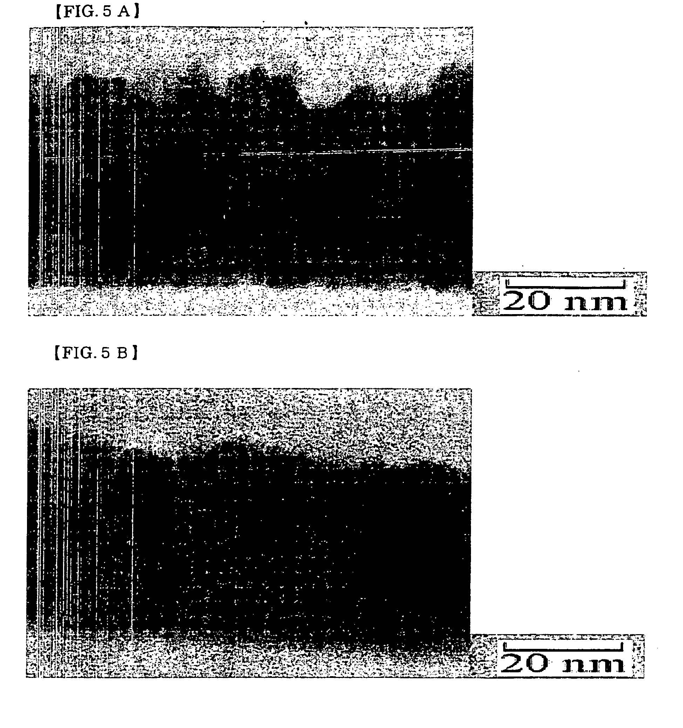

Figs. 5A and 5B are TEM photographs of the cross-sections of the GZO thin films obtained in example 1 and comparative example 1, respectively. It is apparent that the crystal orientation is more aligned to the c axis in the GZO thin film formed on the Al₂O₃ thin film (example 1) than in the GZO thin film with no Al₂O₃ thin film (comparative example 1).

**Table 2**

| | Presence or Absence of Transparent Substrate | Organic Polymer Film Substrate | Undercoat Layer | Target for AZO Thin Film | Evaluations | | | | |
|---|---|---|---|---|---|---|---|---|---|
| | | | | | Initial Resistance (Ro, Ω/square) | Resistance to Moisture and Heat | | | |
| | | | | | | 150°C for 1 Hour | | 150°C for 10 Hour | |
| | | | | | | Resistance (Ω/square) | 85°C and 85%RH for 250 Hours (times) | Resistance (Ω/square) | 85°C and 85%RH for 250 Hours (times) |
| Example 4 | Absence | PET | Al₂O₃ | AZM | 426 | 389 | 3.88 | 405 | 1.10 |
| Example 5 | Absence | PET | Al₂O₃ | AZO | 396 | 321 | 2.14 | 593 | 1.18 |
| Example 6 | Presence | PET | Al₂O₃ | AZM | 435 | - | - | 410 | 1.09 |
| Comparative Example 5 | Absence | PET | Absence | AZM | 647 | 625 | 127 | 884 | 3.00 |
| Comparative Example 6 | Absence | PET | Absence | AZO | 582 | 921 | 31.9 | 2682 | 2.75 |
| Comparative Example 7 | Absence | PET | SiO₂ | AZM | 525 | 608 | 165 | 1222 | 2.46 |
| Comparative Example 8 | Absence | PET | SiO₂ | AZO | 519 | 446 | 4.13 | 536 | 1.38 |

Table 2 indicates that each example shows a relatively low resistance value, a relatively small change in the resistance value under heat or under heat and moisture, and both good heat resistance and good resistance to moisture and heat. It is also apparent that in each example, the resistance to moisture and heat is improved by the annealing process in an environment at 150°C.

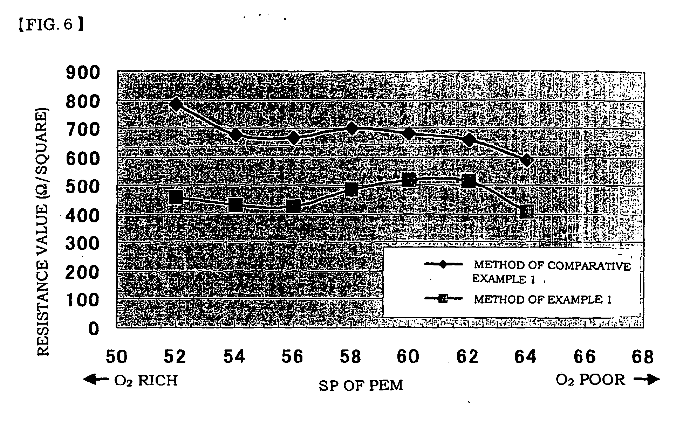

Fig. 6 is a graph showing the relationship between the SP and the resistance value with respect to the AZO thin films formed in the same manner as in example 1 (in which only the SP was changed) and in the same manner as in comparative example 1 (in which only the SP was changed). Fig. 6 also indicates that the resistance value is significantly reduced when the AZO thin film is formed on the Al₂O₃ thin film. In the absence of the undercoat layer of the Al₂O₃ thin film, an increase in the amount of the introduction of oxygen results in a reduction in the oxygen vacancies of the AZO thin film so that the release of carrier electrons from the oxygen vacancies can decrease, and thus the resistance value can increase. On the other hand, in the presence of the Al₂O₃ thin film, the resistance value increases until the SP reaches 60, but the resistance value decreases until the SP reaches 54. This may be because of a change of the film structure. When the SP exceeds 60, the transmittance becomes 50% or less, and thus this case is not preferred in view of transparency. From these points of view, the SP is preferably from 50 to 60, more preferably from 52 to 58. In the above SP range, good transparency is provided. Also in the above SP range, annealing is significantly effective in improving the resistance to moisture and heat.

## Claims

1. A method for producing a transparent conductive film, comprising the steps of:
forming an Al₂O₃ thin film on an organic polymer film substrate; and
forming a ZnO-based thin film on the Al₂O₃ thin film, the ZnO-based thin film including ZnO doped with at least one of Ga and Al, wherein the step of forming the Al₂O₃ thin film is performed by a reactive magnetron sputtering method in a vacuum device evacuated to an ultimate vacuum of 1x10⁻⁴ Pa or less, while the organic polymer film substrate is heated at a temperature of 80 to 180°C.

2. The method according to claim 1, wherein the Al₂O₃ thin film is produced from Al as a metal target under an oxygen-containing argon gas atmosphere by a reactive magnetron sputtering method.

3. The method according to claim 2, wherein the reactive magnetron sputtering method is a reactive dual magnetron sputtering method.

4. The method according to any one of claims 1 to 3, wherein the step of forming the ZnO-based thin film is performed in a vacuum device evacuated to an ultimate vacuum of 1x10⁻⁴ Pa or less, while the organic polymer film substrate is heated at a temperature of 80 to 180°C.

5. The method according to any one of claims 1 to 4, wherein the ZnO-based thin film is a GZO thin film produced from ZnO-Ga₂O₃ as an oxide target under an argon gas atmosphere mainly composed of argon gas by a magnetron sputtering method.

6. The method according to any one of claims 1 to 4, wherein the ZnO-based thin film is a GZO thin film produced from Zn-Ga as a metal target under an oxygen-containing argon gas atmosphere by a reactive magnetron sputtering method.

7. The method according to claim 6, wherein a plasma emission monitor is used to control the amount of the introduction of oxygen into the argon gas atmosphere.

8. The method according to claim 6 or 7, wherein the amount of the introduction of oxygen into the argon gas atmosphere is determined at a set point of 50 to 60, wherein the set point corresponds to a Zn plasma emission peak under the oxygen-containing argon gas atmosphere, when a Zn plasma emission peak produced by electric discharge under argon gas only is defined as 90.

9. The method according to any one of claims 1 to 4, wherein the ZnO-based thin film is an AZO thin film produced from ZnO-Al₂O₃ as an oxide target under an argon gas atmosphere mainly composed of argon gas by a magnetron sputtering method.

10. The method according to any one of claims 1 to 4, wherein the ZnO-based thin film is an AZO thin film produced from Zn-Al as a metal target under an oxygen-containing argon gas atmosphere by a reactive magnetron sputtering method.

11. The method according to claim 10, a plasma emission monitor (PEM) is used to control the amount of the introduction of oxygen into the argon gas atmosphere.

12. The method according to any one of claims 1 to 11, further comprising the step of annealing the resulting transparent conductive film at a temperature of 80 to 180°C after the step of forming the ZnO-based thin film.

## Patentansprüche

1. Verfahren zur Herstellung eines transparenten leitfähigen Films, umfassend die Schritte:
das Bilden eines dünnen Al₂O₃ Films auf einem organischen Polymerfilmsubstrat und
das Bilden eines dünnen Films auf ZnO-Basis auf dem dünnen Al₂O₃ Film, wobei der dünne Film auf ZnO-Basis ZnO dotiert mit mindestens einem von Ga und Al einschließt, wobei der Schritt des Bildens des dünnen Al₂O₃ Films durch ein reaktives Magnetronsputterverfahren in einer Vakuumvorrichtung, evakuiert zu einem äußersten Vakuum von 1x10⁻⁴ Pa oder weniger durchgeführt wird, während das organische Polymerfilmsubstrat bei einer Temperatur von 80 bis 180°C erwärmt wird.

2. Verfahren gemäß Anspruch 1, wobei der dünne Al₂O₃ Film aus Al als einem Metalltarget unter einer sauerstoffhaltigen Argongasatmosphäre durch ein reaktives Magnetronsputterverfahren erzeugt wird.

3. Verfahren gemäß Anspruch 2, wobei das reaktive Magnetronsputterverfahren ein reaktives Dualmagnetronsputterverfahren ist.

4. Verfahren gemäß einem der Ansprüche 1 bis 3, wobei der Schritt des Bildens des dünnen Films auf ZnO Basis in einer Vakuumvorrichtung, evakuiert zu einem äußersten Vakuum von 1x10⁻⁴ Pa oder weniger, durchgeführt wird, während das organische Polymerfilmsubstrat bei einer Temperatur von 80 bis 180°C erwärmt wird.

5. Verfahren gemäß einem der Ansprüche 1 bis 4, wobei der dünne Film auf ZnO Basis ein dünner GZO Film ist, hergestellt aus ZnO-Ga₂O₃ als ein Oxidtarget unter einer Argongasatmosphäre, hauptsächlich aufgebaut aus Argongas, mittels einem Magnetronsputterverfahren.

6. Verfahren gemäß einem der Ansprüche 1 bis 4, wobei der dünne Film auf ZnO Basis ein dünner GZO Film ist, hergestellt aus Zn-Ga als ein Metalltarget unter einer sauerstoffhaltigen Argongasatmosphäre mittels einem reaktiven Magnetronsputterverfahren.

7. Verfahren gemäß Anspruch 6, wobei ein Plasmaemissionsmonitor verwendet wird, um die Menge der Einführung an Sauerstoff in die Argongasatmosphäre zu kontrollieren.

8. Verfahren gemäß Anspruch 6 oder 7, wobei die Menge der Einführung an Sauerstoff in die Argongasatmosphäre bei einer Vorgabe von 50 bis 60 bestimmt wird, wobei die Vorgabe einem Zn-Plasmaemissionspeak unter der sauerstoffhaltigen Argongasatmosphäre entspricht, wenn ein Zn-Plasmaemissionspeak, erzeugt durch elektrische Entladung nur unter Argongas, als 90 definiert wird.

9. Verfahren gemäß einem der Ansprüche 1 bis 4, wobei der dünne Film aus ZnO-Basis ein dünner AZO Film ist, hergestellt aus ZnO-Al₂O₃ als ein Oxidtarget unter einer Argongasatmosphäre, hauptsächlich aufgebaut aus Argongas, mittels einem Magnetronsputterverfahren.

10. Verfahren gemäß einem der Ansprüche 1 bis 4, wobei der dünne Film auf ZnO-Basis ein dünner AZO Film, hergestellt aus Zn-Al als ein Metalltarget unter einer sauerstoffhaltigen Argongasatmosphäre mittels einem reaktiven Magnetronsputterverfahren, ist.

11. Verfahren gemäß Anspruch 10, wobei ein Plasmaemissionsmonitor (PEM) verwendet wird, um die Menge der Einführung an Sauerstoff in die Argongasatmosphäre zu kontrollieren.

12. Verfahren gemäß einem der Ansprüche 1 bis 11, weiter umfassend den Schritt des Temperns des resultierenden transparenten leitfähigen Films bei einer Temperatur von 80 bis 180°C nach dem Schritt des Bildens des dünnen Films auf ZnO-Basis.

## Revendications

1. Une méthode de production d'un film transparent conducteur, comprenant les étapes de :
formation d'une couche mince d'Al₂O₃ sur un substrat constitué d'un film polymère organique ; et
formation d'une couche mince à base de ZnO sur la couche mince d'Al₂O₃, la couche mince de ZnO incluant du ZnO dopé avec au moins un de Ga et d'Al, dans laquelle l'étape de formation de la couche mince d'Al₂O₃ est réalisée par une méthode de pulvérisation magnétron réactive dans un dispositif sous vide évacué à un vide final de 1x10⁻⁴ Pa ou moins, tandis que le substrat constitué d'un film polymère organique est chauffé à une température de 80 à 180°C.

2. La méthode selon la revendication 1, dans laquelle la couche mince d'Al₂O₃ est produite à partir d'Al en tant que cible métallique sous une atmosphère de gaz argon contenant de l'oxygène par une méthode de pulvérisation magnétron réactive.

3. La méthode selon la revendication 2, dans laquelle la méthode de pulvérisation magnétron réactive est une méthode de pulvérisation réactive à deux magnétrons.

4. La méthode selon l'une quelconque des revendications 1 à 3, dans laquelle l'étape de formation d'une couche mince à base de ZnO est réalisée dans un dispositif sous vide évacué à un vide final de 1x10⁻⁴ Pa ou moins, tandis que le substrat constitué d'un film polymère organique est chauffé à une température de 80 à 180°C.

5. La méthode selon l'une quelconque des revendications 1 à 4, dans laquelle la couche mince à base de ZnO est une couche mince de GZO produite à partir de ZnO-Ga₂O₃ en tant que cible d'oxyde sous une atmosphère de gaz argon principalement composée de gaz argon par une méthode de pulvérisation magnétron.

6. La méthode selon l'une quelconque des revendications 1 à 4, dans laquelle la couche mince à base de ZnO est une couche mince de GZO produite à partir de Zn-Ga en tant que cible métallique sous une atmosphère de gaz argon contenant de l'oxygène par une méthode de pulvérisation magnétron réactive.

7. La méthode selon la revendication 6, dans laquelle un détecteur d'émission de plasma est utilisé pour contrôler la quantité de l'introduction d'oxygène dans l'atmosphère de gaz argon.

8. La méthode selon la revendication 6 ou 7, dans laquelle la quantité de l'introduction d'oxygène dans l'atmosphère de gaz argon est déterminée en un point déterminé de 50 à 60, dans laquelle le point déterminé correspond à un pic d'émission de plasma de Zn sous l'atmosphère de gaz argon contenant de l'oxygène, lorsqu'un pic d'émission de plasma de Zn produit par décharge électrique sous gaz argon uniquement est définie comme étant 90.

9. La méthode selon l'une quelconque des revendications 1 à 4, dans laquelle la couche mince à base de ZnO est une couche mince d'AZO produite à partir de ZnO- Al₂O₃ en tant que cible d'oxyde sous une atmosphère de gaz argon principalement composée de gaz argon par une méthode de pulvérisation magnétron.

10. La méthode selon l'une quelconque des revendications 1 à 4, dans laquelle la couche mince à base de ZnO est une couche mince d'AZO produite à partir de Zn-Al en tant que cible métallique sous une atmosphère de gaz argon contenant de l'oxygène par une méthode de pulvérisation magnétron réactive.

11. La méthode selon la revendication 10, dans laquelle un moniteur d'émission de plasma (PEM) est utilisé pour contrôler la quantité de l'introduction d'oxygène dans l'atmosphère de gaz argon.

12. La méthode selon l'une quelconque des revendications 1 à 11, comprenant en outre l'étape de recuire le film conducteur transparent résultant à une température de 80 à 180°C après l'étape de formation de la couche mince à base de ZnO.
